# EUROPEAN PATENT APPLICATION

(11) **EP 4 727 264 A1**
(43) Date of publication of application: **15.04.2026**
(21) Application number: 24206179.4
(22) Date of filing: 11.10.2024
(51) Int. Cl.: H05K 1/02, H05K 1/18, H05K 3/22, H05K 5/02

(54) **ELECTRONIC DEVICE WITH ELECTRONICS MOUNTED ON A FLEXIBLE SUBSTRATE, AND METHOD FOR REMOVING ELECTRONICS**

(71) Applicant: Nederlandse Organisatie voor toegepast- natuurwetenschappelijk onderzoek TNO, 2595 DA 's-Gravenhage (NL)
(72) Inventor: DE KOK, Margaretha Maria, 2595 DA 's-Gravenhage (NL); RENSING, Petrus Alexander, 2595 DA 's-Gravenhage (NL); VAN DER WAAL, Adri, 2595 DA 's-Gravenhage (NL)
(74) Representative: V.O.

(57) **Abstract**

An electronic device is disclosed, comprising a casing with a compartment that encloses an electronic circuit with one or more circuit parts provided on a flexible substrate. An attachment area of the flexible substrate is attached to a mounting plane inside the compartment. A pull tab extends from the attachment area and passes through a slot such that the pull tab is engageable from the outside of the compartment. A position of the slot with respect to the mounting plane is arranged for causing a local bending and/or stretching of the attachment area in response to a mechanical pull force on the pull tab. This creates a local stress concentration in the attachment area that propagates and detaches the flexible substrate from the mounting plane. The detached flexible substrate can be removed from the compartment through the slot.

## Description

The invention relates to an electronic device comprising a casing with a compartment that encloses an electronic circuit with one or more circuit parts and components provided on a flexible substrate. The invention further relates to a method for removing the set of electronics from the electronic device.

Current recycling of products containing electrical or electronic functionalities (WEEE) is usually performed in specialized waste processing companies, and starts with shredding products into pieces by which the PCB (printed circuit board) is separated from plastics and other metal fractions based on various techniques, e.g. making use of magnetism, Eddy currents, or air push. For example, in current process technologies separation of electronics from other waste is focused on FR4 board (PCB and PCBA) housing metal (e.g. Copper) electronics and components. Rigid FR4 boards typically concentrate electronics in a small area. Such rigid boards can therefore be separated from the shredded fractions by detecting Eddy currents and directing air push to remove the boards from the waste flow.

However, flexible electronic substrates may not be compatible with such conventional waste processing flows. Flexible electronic substrates generally include a limited fraction of metal on a relatively large area. Furthermore, the fact that the substrate is flexible and lightweight causes conventional methods of separation to be ineffective, and the flexible electronic substrate is most likely to end up in the plastics fraction of the waste processor company, or in landfills or incinerations. This not only pollutes the plastics recycling schemes but also prevents circular use of materials including electronics.

It may not be preferred to adapt electronics carried by flexible substrates so that they become compatible with existing separation processes, e.g. by including more metal in the flexible substrate, because this creates a larger ecologic footprint, and the higher metal content may complicate further downstream recycling steps. Another option of concentrating the electronics on a certain restricted area making them more susceptible for Eddy current separation takes away the advantage of flexible electronics in which functionalities can be distributed over larger areas.

Hence, it remains a challenge to efficiently recycle flexible electronic substrates.

### SUMMARY

To address the abovementioned issue, aspects of the invention relate to an electronic device as defined in the appended claims. The electronic device comprises a casing with a compartment that encloses an electronic circuit with one or more circuit parts provided on a flexible substrate. An attachment area of the flexible substrate is attached to a mounting plane inside the compartment. A wall of the compartment comprises a slot that provides a passage between an inside and outside of the compartment, and the flexible substrate comprises a pull tab that extends from the attachment area and passes through the slot such that the pull tab is engageable from the outside of the compartment.

A position (e.g. distance and orientation) of the slot with respect to the mounting plane is arranged for causing a local bending and/or stretching of the attachment area in response to a mechanical pull force on the tab, for thereby creating a local stress concentration in the attachment area that propagates and detaches the flexible substrate from the mounting plane. Furthermore, the slot is dimensioned to allow removal of the detached flexible substrate from the compartment through the slot.

In other words, the flexible substrate can be separated from the electronic device, simply by pulling the pull tab from the outside of the compartment. The pull tab may be an integral part of the flexible substrate, or can be a separate part, e.g. a string or flap, that is attached to the flexible substrate. A pulling action on the pull tab, i.e. in a direction away from the compartment, causes the flexible substrate to detach from its seat inside the compartment, after which the flexible substrate in its entirety can be pulled out of the compartment through the slot. Hence, it is not necessary to open or break the casing in order to access and remove the internal electronics. Also, it is not necessary to use heat, radiation, or other means to separate the flexible substrate from the casing. As a result, the flexible substrate can be separated from the electronic device by a consumer, so that the electronic components and the device casing can be disposed by the consumer in separate waste streams, e.g. in a way similar to how batteries can be removed from an electronic device and disposed separately, before the waste is processed in conventional waste processes. Also in waste processor facilities this removal of electronics can be achieved, even automatically. The present invention makes use of the unique form factors of flexible (e.g. printed) electronics, being thin, flexible and conformable, to allow removal of the flexible substrate from other parts of the device. For example, the flexible substrate may be shaped in such a way that the distribution of the electronics that are supported by the substrate in the compartment is achieved in one or more three-dimensional directions. Because of the flexibility and/or stretchability of the substrate the electronic components can more easily be removed from the housing than rigid electronics. In response to the mechanical pull force a flexible and/or stretchable substrate can move while optionally changing its shape, allowing it to leave via a relatively narrow opening (i.e. slot).

Hence, the present invention provides a way to efficiently remove electronic components, e.g. by the consumer before the electronic device is disposed at its end of life, or by automated or manual handling in an initial process stage at a waste recycling plant, e.g. at or immediately after the depollution stage that is mandatory for removal of hazardous elements. Once discarded by the consumer or at recycling facilities the electronics can be removed from devices in an early phase, liberating the precious, strategic and possibly even critical metals and plastics from the housing without the need for shredding and automated sorting steps that are typically less effective for thin and/or flexible substrates. Early separation of electronics from the housing will allow more cost-efficient recycling.

The consumer can remove the electronic components from the product because the flexible substrate holding the electronic components can be pulled out the device, and therefore not the entire device needs to be offered as electronic waste but only the electronic fraction, e.g. similar to how batteries are collected and processed. In order to achieve this, the flexible substrate is designed in such a way that it can be detached from the mounting plane inside the compartment by a mechanical pull force, which causes local bending and/or stretching of the flexible substrate at the attachment area. This in turn causes a local stress concentration in the attachment (e.g. adhesive layer) between the flexible substrate and the mounting plane, which local stress concentration propagates through the attachment and peels off the flexible substrate from its mounting plane. By creating a propagating local stress concentration, e.g. peeling action, relatively little force is required for detaching the flexible substrate, while in absence of a mechanical pull force on the tab the flexible substrate remains in place. Peeling actions may be further enhanced by dedicated designs of the substate for electronics as well as relevant coatings underneath to provide a sturdy assembly to the housing during usage of the product, e.g. by adhesives. Alternatively, or additionally, an adhesive coating with a pattern that allows an initiation of the delamination / peeling process can be used, e.g. by locally interrupting the adhesive layer near the edge of the attachment area that is to be peeled off first.

The thus induced peeling process of the flexible substrate from the mounting plane, preferably involves a combination of mechanical forces, dedicated designs or foils and coatings, as well as material behaviors. For example, the peeling typically starts at an edge or a point where the mechanical pull force from the pull tab is applied to the attachment area. This creates a localized stress concentration at the peeling point. As the mechanical pull force is applied, the adhesive or bonding material at the interface between the attachment area and the mounting plane may experience a combination of shear and tensile stresses. In general, the tensile stress tends to pull the adhesive apart, while shear stress tries to slide the adhesive layers against each other. If the applied force is sufficient to overcome the bond's strength at the peeling point, a crack or separation begins at the interface. This crack can be regarded as the initial point of failure in the bond. As the crack forms, stored elastic energy in the materials is released. This energy can be used to drive the crack to propagate along the attachment area as peeling continues. Dedicated features in the design of the foil and/or functional coatings, e.g. adhesives, may provide an initial weakness to the assembly that serves to cascade the peeling action. Alternatively, dedicated features may also include design features that establish a barrier to avoid an accidental peeling action. For example, in some embodiments, the attachment area is connected to the mounting plane by a patterned layer of first adhesive areas and second adhesive areas, and/or non-adhesive areas. For example, a first adhesive may be present in one or more first areas, and a second adhesive or no adhesive may be present in one or more second areas, wherein the first adhesive is stronger than the second adhesive. By increasing the concentration of non- or lower strength adhesive areas near an edge of the attachment area that is to be peeled first from the mounting plane, an initial weakness is provided. Conversely, by adding an increased concentration of higher strength adhesive areas near said front edge, an initial barrier is provided. In other words, the strength of the adhesive can locally be increased or decreased near an edge of the attachment area that is to be peeled off first, by providing a patterned layer of adhesive. For example, the patterned layer may comprise different types of adhesives, or different chemistries, or specific areas that are devoid of an adhesive.

As peeling progresses, the stress is redistributed along the attachment area. The edge where peeling is occurring experiences the highest stress, while the remaining bonded area experiences lower stress levels. The adhesive or other type of bonding may stretch and deform elastically and plastically before it finally separates. In some cases, the adhesive or bonding may undergo cohesive failure (where it tears within itself) or adhesive failure (where it separates from one of the surfaces).

The angle at which peeling occurs may significantly affect the mechanical behavior. A higher peel angle (close to perpendicular to the bonded surface) generally increases the tensile component of the stress, leading to easier separation. A lower peel angle increases the shear component, making peeling more difficult. Depending on the peel angle and the material of the adhesive or other type of bond, the separation could be more cohesive or adhesive. Important is to architect the bending radius of the substrate that the pulling action enforces which should not lead to rupture of the electronics from the substrate. Moreover in the sliding of the substrate out of the device friction between components being present on the substrate should be avoided as to not cause contact between components resulting in shear forces rupturing components.

This process is complex and depends on various factors, including the properties of the bonded materials, the type of bond, the environment (temperature, humidity), the speed and angle of peeling and optional design features of the coating, including the use of more than one adhesives to either weaken or strengthen the initial point from which a peeling action occurs.

The flexibility and stretchability allow the flexible substrate to change shape so that it can be pulled through a relatively narrow slot. Preferably, the slot has a slot height that is between 1 and 3 times a maximum thickness of the flexible substrate including the circuit parts. For example, the flexible substrate may in itself have a thickness of a few tenths of a millimeter, or even less. Conversely, the circuit parts on the flexible substrate may have a thickness between 0,5 and 2 millimeters, or more.

Furthermore, the inherent properties of the flexible substrate make it able to bend, fold, or roll up in response to the mechanical pull force on the tab. As a result the width of the slot can be smaller than the original width of the flexible substrate, i.e. in undeformed condition. For example, the width of the slot may be less than half the original width of the flexible substrate. This is typically not possible with rigid electronics, e.g. PCB assemblies, which can only be accessed and removed though an opening that is larger than the size of the rigid board.

Preferably, the attachment area is bendable in an out-of-plane direction of the flexible substrate, and the slot is preferably located and/or tilted at an out-of-plane distance and/or orientation relative to the mounting plane that provides a non-zero peel angle of the tab with respect to the mounting plane, such that the attachment area is peeled from the mounting plane in response to a mechanical pull force on the tab. In other words, the mechanical pull force on the tab creates a load on the flexible substrate with an out-of-plane component that peels the attachment area from the mounting plane. Said out-of-plane component is induced by the non-zero peel angle, i.e. the attachment area is locally lifted from the mounting plane. The slot may be provided at a distance or height above the mounting plane, such that the tab runs upward, away from the attachment area before it extends through the slot, hence creating a non-zero peel angle, e.g. a peel angle between 30 and 90 degrees between the tab and the mounting plane.

The effect is that a mechanical pull force on the distal end of the pull tab causes a local bending or stretching of the flexible substrate, which starts at an edge of the attachment area but propagates further across the attachment area as the flexible substrate is gradually detached from the mounting plane due to the local stress concentration in the connection (e.g. adhesive). Due to the propagation, the peel angle may change as a larger portion of the attachment area is detached from the mounting plane. The position of the slot with respect to the mounting plane may be arranged for creating a minimum peel angle, e.g. a peel angle of at least 10 degrees, preferably at least 20 or 30 degrees, to facilitate the removal of the flexible substrate from the device.

Preferably, the initial peel angle is at least 45 degrees, preferably 90-180 degrees. A peel angle of more than 90 degrees, like a peel angle of about 180 degrees or more corresponds with the pull tab being bent or folded back on itself. When the initial peel angle is about 180 degrees, the tab is more or less parallel to the mounting plane and the peel angle remains substantially constant as the tab is pulled further out the compartment. In other words, the mechanical force leads to a 180 degree peel movement to release electronics carried by a flexible substrate from the product. This solution cannot be achieved with conventional PCBs as these electronics are rigid and cannot be removed from a device as proposed.

In order to facilitate removal of the flexible substrate, at the attachment area the bend radius of the flexible substrate is smaller than 10 millimeter, preferably smaller than 5 millimeter. The flexible substrate is able to bend with such a radius without breaking, as opposed to conventional rigid PCB assemblies. A larger bend radius makes it more difficult to separate the attachment area from the mounting plane, since the level of stress concentration is reduced. In other words, in order to increase the concentration of stress in the connection between the attachment area and the mounting plane, the bend radius is preferably as small as possible.

In general, the material and thickness of the flexible substrate as described herein allows a sub-millimeter bending radius. However, the presence of rigid electronic components such as processors or IC's on the flexible substrate may locally reduce the bendability of the flexible substrate. For this reason, it may be preferred that said rigid electronic components cover a relatively small area of the attachment area, preferably having an in-plane dimension that is smaller than the desired minimum bend radius of the flexible substrate. Optionally, the rigid electronic components may be spaced apart and/or organized in a pattern that facilitates bending of the flexible substrate. For example, the components may be arranged in rows that extend transverse to the bending direction and that are spaced apart in the bending direction, such that a polygonal shape is formed in some parts of the flexible substrate when the attachment area is detached from the mounting plane.

In some embodiments, the attachment area of the flexible substrate comprises a stretchable section that is stretchable in an in-plane direction, and the stretchable section is stretched in response to a mechanical pull force on the tab. The stretching or elongation causes a local deformation of the attachment area away from the mounting plane, which in turn creates a local stress concentration, or peeling action, that detaches the attachment area from the mounting plane. This phenomenon can also occur when the slot is substantially aligned in plane with the mounting plane, such that the flexible substrate does not bend when a mechanical pull force is applied on the tab, but only stretches out. Said stretchability can thus be exploited as an alternative to a bendability of the substrate. The stretchability can also be made use of in combination with bendability of the flexible substrate. For example, the slot may be positioned at an out-of-plane distance from the mounting plane. In response to a mechanical pull force on the tab, the flexible substrate may thus simultaneously bend and stretch locally at the attachment area, thereby creating a "double peeling" action which further facilitates removal of the flexible substrate from the electronic device.

In order to maintain the integrity of the flexible substrate as it is detached from the mounting plane, and to remove the flexible substrate from the electronic device in one piece, the stretchable section preferably has an elongation at break, defined by dividing a length at break of the stretchable section by an original length of the stretchable section, of at least a factor 2.

In preferred embodiments the attachment area is attached to the mounting plane by an adhesive, in particular an adhesive with a peel strength that is weaker than a tensile strength of the flexible substrate. For example, the tensile strength of the flexible substrate may be at least a factor 2 higher than the peel strength of the adhesive, to avoid that the flexible substrate breaks before it is peeled off from the mounting plane.

Alternatively, the attachment area may be attached to the mounting plane by a soldered connection, e.g. comprising one or more solder pads or solder joints in an array of contact points. Similar to an adhesive connection the soldered connection can be severed by a peeling action caused by the flexible substrate locally bending and/or stretching with respect to the mounting plane, thereby generating a local stress concentration that propagates from one solder joint to the next, until the flexible substrate is completely detached from the mounting plane.

As mentioned earlier, the flexible substrate, or flex foil, may optionally include one or more rigid circuit parts like IC's, processors, resistors, SMD components, or capacitors. In preferred embodiments the flexible substrate comprises one or more circuit parts that are printed on the substrate. In other words, the flexible substrate may be a printed electronic substrate. Circuit parts and other electronic components may be printed onto the substrate using common industrial printing processes such as screen printing, flexography, gravure, offset lithography, and inkjet.

Electrically functional electronic or optical inks may be deposited on the substrate, creating active or passive devices, such as thin film transistors, capacitors, coils, or resistors. The substrate itself may comprise a flexible foil, e.g. made of polyethylene terephthalate (PET) which has a low cost and moderately high temperature stability. Alternatively, a foil or substrate made of polyethylene naphthalate (PEN) or polyimide (PI) can be used, or other suitable materials known in the art including stretchable substrates like silicones or thermoplastic polyurethanes (TPU) or polyvinylbutyral (PVB).

In some embodiments, the pull tab is connected to a battery unit of the electronic device. In this way, when the battery unit is removed from the device, the flexible substrate can be removed as well. For example, the pull tab of the flexible substrate may extend through the slot and may be coupled to the battery unit on the outside of the compartment. Preferably, individual batteries can be replaced from the battery unit without pulling out the flexible substrate, since the device itself may not be at its end of life.

To achieve this, the battery unit may include a battery housing in which one or more individual batteries can be operatively installed and replaced, wherein the battery unit in its entirety can be removed from the electronic device when the device is to be disposed as waste. Consumers nowadays are more prone to remove batteries and have them collected separately than discard their WEEE in proper ways. Note that batteries (not considered part of WEEE) are recycled to a relatively high extent. According to European statistics up to 50 % of batteries sold are recycled.

This indicates that consumers can be educated to remove other parts of a product, in particular flexible electronic substrates, especially when the flexible substrate is connected to the battery unit. Normally, batteries are accessible in products by design whereas PCB boards are typically well buried in a product and not meant to be removed by a consumer.

To prevent accidental or unintended removal of the flexible substrate from the electronic device, the casing may comprise a removable cover that covers the slot. In this way it can be prevented that by accident or misuse the electronic device is made non-operational before its end of life. Alternatively, or additionally, the pull tab may be secured to the casing on the outside of the compartment, e.g. by an adhesive connection. Accordingly, a user may first need to peel the pull tab from the outside of the compartment, before a mechanical pull force can be exerted on the pull tab to peel the flexible substrate from the mounting plane inside the compartment. In case a removable cover covers the slot, the pull tab may optionally be attached to the removable cover. In this way, the removable cover can be used as a handle, or lever, for applying a mechanical pull force on the pull tab.

The present invention is not limited to any size or shape of flexible substrate. For example, the flexible substrate may be rectangular, square, or may have a more complex geometry including one or more bends or cutouts. Similarly, various sizes and shapes of the attachment area and pull tab are possible, including relative positions and orientations of the slot with respect to the mounting plane, as long as the flexible substrate can be removed from the electronic device though the slot, without opening or breaking the casing of the device, preferably without breaking the flexible substrate, by exerting a mechanical pull force on the pull tab that creates a local bending and/or stretching at the attachment area, thereby forming a local stress concentration in the connection between the attachment area and the mounting plane that propagates and detaches the flexible substrate from the casing. In some embodiments, the flexible substrate comprises a plurality of branches that are interconnected at the pull tab, and each branch comprises an attachment area that is attached to a respective mounting plane on the inside of the casing. Hence, by pulling on the pull tab, all branches of the flexible substrate can be detached from their respective mounting planes.

In other aspects, the present invention provides a method for removing the set of electronics from the electronic device described herein. The method comprises accessing, e.g. by an operator of a waste processing plant, the tab of the flexible substrate from an exterior of the casing and applying a mechanical pull force on the tab. Accordingly, the flexible substrate including electronic parts can be separated from the rest of the electronic device so that these can be processed in separate waste streams.

### BRIEF DESCRIPTION OF THE DRAWINGS

The invention will be further elucidated in the figures:
FIG. 1 illustrates an embodiment of an electronic device with a flexible substrate that is detachable from the device by means of an external pull force that causes a peeling action, wherein the substrate is removable through a slot in a sidewall of the casing of the device;
FIG. 2 provides a section view of the electronic device, further indicating the position of the slot relative to the flexible substrate;
FIG. 3 provides another or further embodiment of the electronic device, in which the slot is provided in an upper wall of the casing to increase the peel angle;
FIG. 4 illustrates yet another or further embodiment of the electronic device, in the relative position of the slot brings the flexible substrate into a 180 degree peel when a pull force is applied on the pull tab;
FIG. 5 illustrates another or further embodiment of the electronic device in which a stretchability of the substrate is exploited to detach the substrate from the casing;
FIG. 6 provides an embodiment in which the electronic device further comprises a battery unit that is attached to the pull tab;
FIG. 7 illustrates an embodiment of the electronic device wherein the flexible substrate has multiple branches;
FIG. 8 provides a schematic representation of a method for removing the flexible substrate from the electronic device as described herein.

### DETAILED DESCRIPTION

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

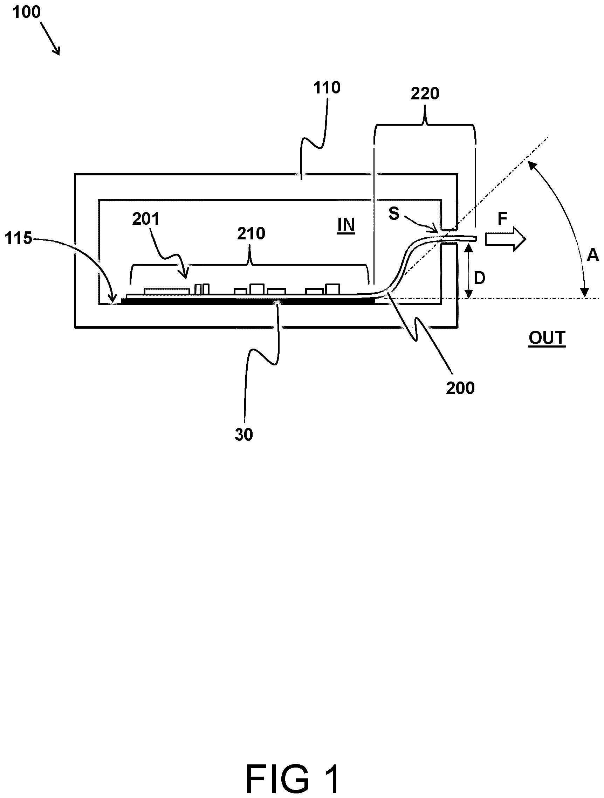

FIG 1 illustrates an embodiment of an electronic device 100 for use by private consumers or for industrial use. The electronic device 100 can be any device including electronic components, like a laptop or computer, a photo/video camera, a radio, or a toy, or industrial equipment like a measurement device or robotic arm. The electronic device 100 comprises a casing 110, e.g. made of a plastic or metal, with a compartment that encloses an electronic circuit with one or more circuit parts 201 provided on a flexible substrate 200. One or more of the circuit parts 201 may be rigid circuit parts. In some embodiments, the flexible substrate 200 is a printed electronics substrate, e.g. comprising one or more printed circuit parts.

In the context of the present invention, the flexible (electronic) substrate can be defined as a thin, bendable material that serves as the foundation for building electronic circuits. Unlike traditional rigid substrates like silicon, e.g. as used in conventional PCB assemblies, flexible substrates allow electronic components such as transistors, resistors, and capacitors to be printed or mounted on materials that can bend, twist, or even stretch. This flexibility enables the development of devices that can conform to various shapes or move without breaking the circuits. Common materials for flexible electronic substrate films include terephthalate (PET), polyimides and other polymers. These thickness of such flexible substrates is typically less than 1 millimeter, e.g. 0,1-0,5 millimeter, providing a thin and lightweight film that is capable of being bent, rolled or folded without breaking.

An attachment area 210 of the flexible substrate 200 is attached to a mounting plane 115 inside the compartment 110, e.g. by means of a layer of adhesive 30, by a soldered connection, or any other type of bond, to keep the flexible substrate 200 in place during normal use of the electronic device 100. Preferably the adhesive, or bond, has a peel strength that is weaker than a tensile strength of the flexible substrate 200 to avoid breakage of the flexible substrate 200 as it is peeled from the mounting plane 115.

A slot S is provided in one of the walls of the compartment, e.g. in a side wall. The slot S provides a passage between an inside IN and an outside OUT of the compartment 110. The flexible substrate 200 comprises a pull tab 220 that extends from the attachment area 210 and passes through the slot S such that a distal end of the pull tab 220 is engageable from the outside OUT of the compartment. The pull tab 220 may be an integral part of the flexible substrate 200, and one or more circuit parts 201 may be mounted on a portion of the pull tab 220. Alternatively, the pull tab 220 may be formed by a separate part like a string or flap that is connected to the attachment area 210.

As illustrated in FIG. 1, the slot S is located at a height H above the mounting plane 115. Accordingly, when a mechanical pull force F is applied on the pull tab, this causes a local bending and/or stretching of the attachment area 210. This in turn creates a local stress concentration in the attachment area 210 that propagates from an initial peeling point, e.g. an edge of the attachment area 210 that is closest to the slot S, across the attachment area 210. As the pull tab 220 is pulled further out the compartment 110 the propagating local stress concentration causes a severing of the bond between the attachment area 210 and the mounting plane 115, until the flexible substrate 200 is completely detached from the mounting plane 115, and the flexible substrate 200 can be removed in its entirety by pulling it through the slot S.

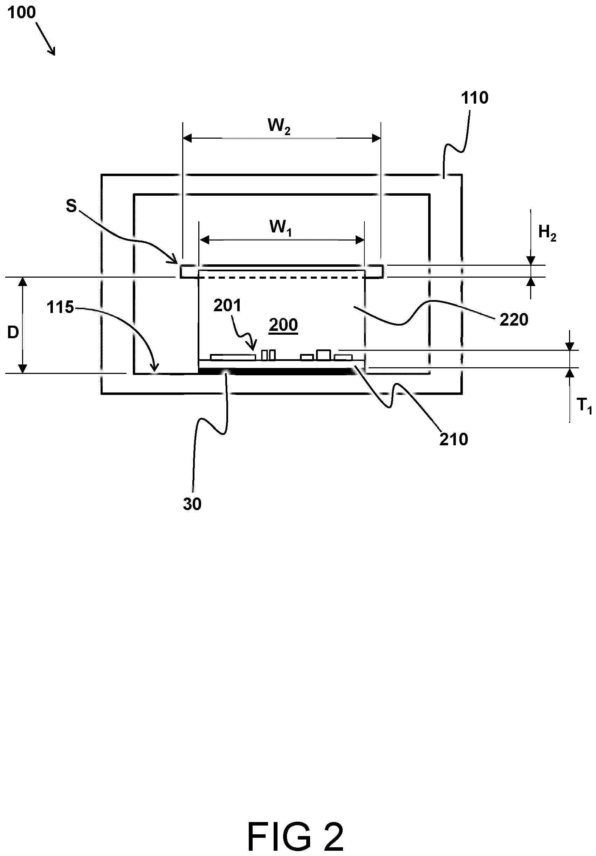

FIG. 2 provides a section view of the electronic device 100, further illustrating how the pull tab 220 of the flexible substrate 200 extends from the attachment area 210 towards and through the slot S. The slot S is narrow, in that the slot height H2 of the slot is at least a factor 3 smaller than the slot width W2 of the slot, preferably at least a factor 5 smaller. The slot height H2 is preferably between 1 and 3 times a maximum thickness T1 of the flexible substrate 200 including the circuit parts 201, in order to allow the flexible substrate 200 including circuit parts 201 to be removed from the compartment 110 though the slot S. For example, the flexible substrate 200 may have a thickness of 0,1-0,5 millimeter, and the circuit parts 201 may have a thickness, or height with respect to the surface of the flexible substrate 200, of e.g. 0,5-3 millimeters. Hence, in that case the maximum thickness T1 may be up to 3,5 millimeters, and the slot height H2 should be at least 3,5 millimeters to allow passage of the flexible substrate through the slot S. Preferably, the slot height H2 is not more than 3 times the maximum thickness of the flexible substrate including circuit parts, to prevent ingress of dirt, fluids, and other objects into the compartment 110. The slot width W2 is preferably not larger than 1,5 times the width W1 of the flexible substrate. A wider slot is not required to allow passage of the flexible substrate through the slot S. In specific embodiments, the slot width W2 may even be smaller than the width W1 of the substrate, e.g. less than half the width W1. It may be understood that the width W1 and maximum thickness T1 of the flexible substrate including circuit parts can have any value, depending on the type of substrate and type of circuit parts mounted thereon, and that the slot dimensions can be adjusted accordingly.

As illustrated in FIGs. 1 and 2, the attachment area 210 of the flexible substrate is bendable in an out-of-plane direction, and the slot S is located at a distance D from the mounting plane 115 that provides a non-zero peel angle A of the pull tab 220 with respect to the mounting plane 115. Accordingly, when a mechanical pull force F is applied on the pull tab the attachment area 210 is peeled from the mounting plane 115. The pull angle A changes as the attachment area 210 is further detached from the mounting plane 115. For example, in the embodiment sketched in FIG. 1, the peel angle A decreases as the local stress concentration in the adhesive layer 30 propagates in a direction away from the slot S. Preferably, the peel angle A initially is at least 45 degrees. The magnitude of force F needed to peel the flexible substrate 200 from the mounting plane 115 can be decreased by increasing the peel angle A. A large peel angle A can for example be obtained by positioning the slot S at a larger distance D above the mounting plane 115.

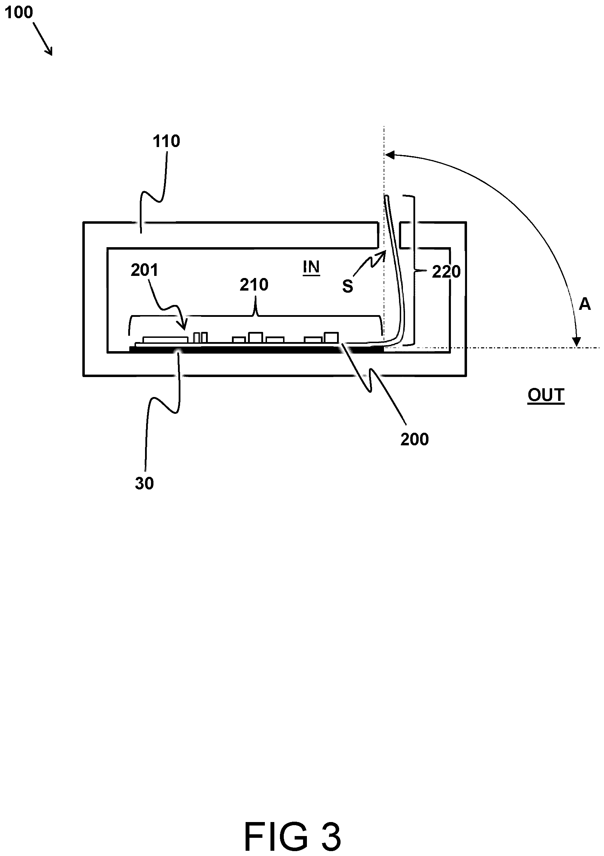

See for example FIG. 3, illustrating an embodiment in which the slot S is located in a wall of the compartment 110 opposite the mounting plane 115. Here, the initial peel angle A is about 90 degrees, and the peel angle A will decrease as the attachment area 210 is detached from the mounting plane 115.

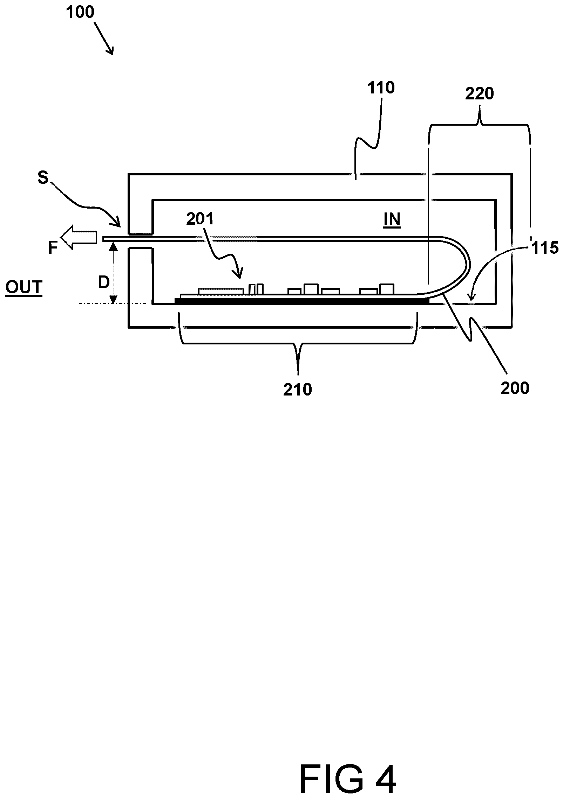

Another example is provided in FIG. 4, where an embodiment of the electronic device 100 is illustrated in which the pull tab 220 extends from the a first side of the attachment area 210, and the slot S is provided in a wall of the compartment 110 on a second side of the attachment area 210 opposite the first side. The pull tab 220 is bent or folded backwards, so that it extends back onto itself and across the attachment area before it passes through the slot S and exits the compartment 110. This creates a peel angle A of about 180 degrees. The benefit of such a 180-degree peel is that the peel angle A remains relatively constant as the attachment area 210 is peeled from the mounting plane 115. Preferably the distance D between the slot S and the mounting plane 115 is at least twice as large as the total thickness T1 of the flexible substrate 200 including any circuit parts mounted thereon, to avoid that circuit parts 201 on the upper and lower part of the flexible substrate 200 interlock with each other and prevent further movement of the flexible substrate 200 through the slot S.

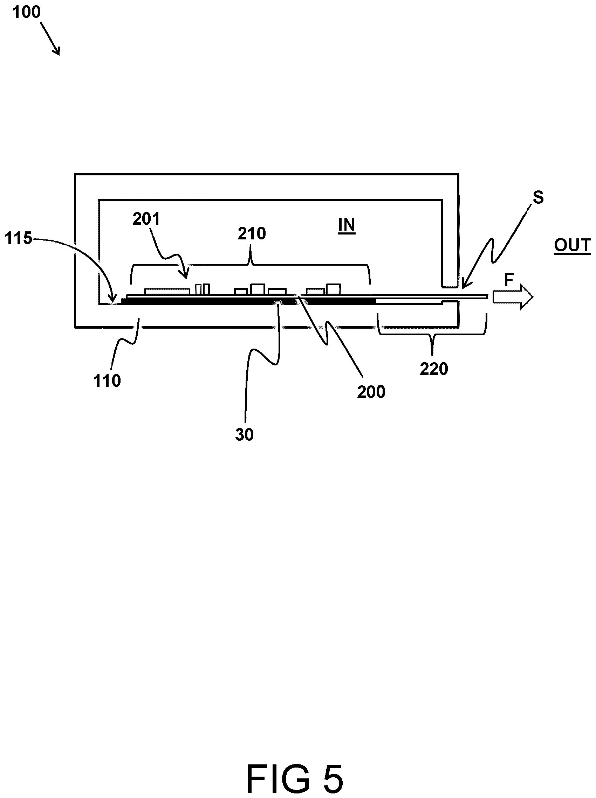

As mentioned earlier in the present disclosure, the flexible substrate 200 may have an in-plane flexibility, or stretchability. This property can be used to remove the flexible substrate from the compartment. For example, in some embodiments of the present invention, the attachment area 210 of the flexible substrate is stretchable in an in-plane direction. Hence, when a mechanical pull force F is applied on the pull tab, the flexible substrate is stretched, or elongated, in the direction of the mechanical pull force F. When the attachment area 210 is stretched out, a local stress concentration is induced in the adhesive layer 30 or bond between the stretched out portion of the attachment area 210 and the mounting plane 115. Said stretching may occur in combination with bending of the flexible substrate 200 when the slot S is positioned to provide a non-zero peel angle A, thereby creating a "double peeling" action. In other words, the local bending and the local stretching of the flexible substrate 200 may occur simultaneously, and jointly contribute to peeling the flexible substrate from the mounting plane. However, as illustrated in FIG. 5, in some embodiments the slot S may be arranged substantially in plane with the mounting plane 115, e.g. at the same level, so that the peel angle is negligible or zero. In such cases, the flexible substrate 200 does not bend in response to the mechanical pull force F on the pull tab, but is only stretched out in the pull direction.

The flexible substrate does not need to be stretchable over its full length. For example, the pull tab 220 may not be stretchable. Preferably, the flexible substrate 200 has a stretchable section. The stretchable section may cover at least a part of the attachment area 210. Preferably, the stretchable section has an elongation at break, defined by dividing a length at break of the stretchable section by an original length of the stretchable section, of at least a factor 2.

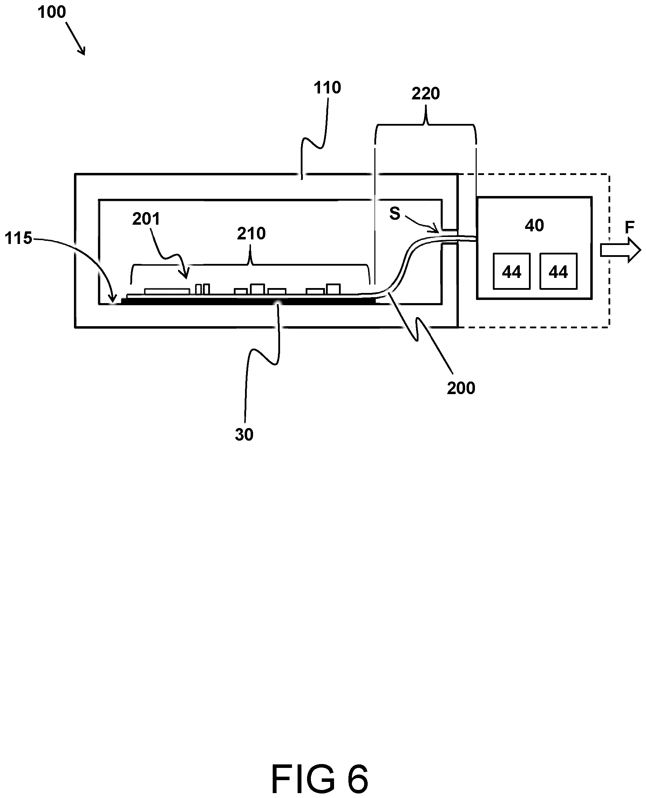

FIG. 6 illustrates another or further embodiment of the electronic device 100, further comprising a battery unit 40. The battery unit 40 may comprises a battery housing 41 and one or more individual batteries 44 that are held inside the battery housing 41 and can be replaced by a user. The battery unit may be removably mounted to the casing outside the electronics compartment, e.g. adjacent the wall of the compartment 110 in which the slot S is provided. Accordingly, the pull tab 220 of the flexible substrate may extend through the slot S and connect to the battery unit 40. In this way, when the user removes the battery unit 40 from the casing, the flexible substrate 200 can be pulled along with the battery unit 40, thereby detaching the attachment area 210 from the mounting plane 115. By pulling the battery unit 40 further away from the compartment 110, the flexible substrate 200 can be pulled through the slot S and removed from the compartment 110 in its entirety.

Alternatively, or additionally, the casing of the electronic device may comprise a removable cover that covers the slot S, to prevent misuse or unintended removal of the flexible substrate 200. Such a removable cover may be attached to the pull tab 220, so that when the removable cover is pulled away from the compartment 110, the flexible substrate 200 is detached and pulled out.

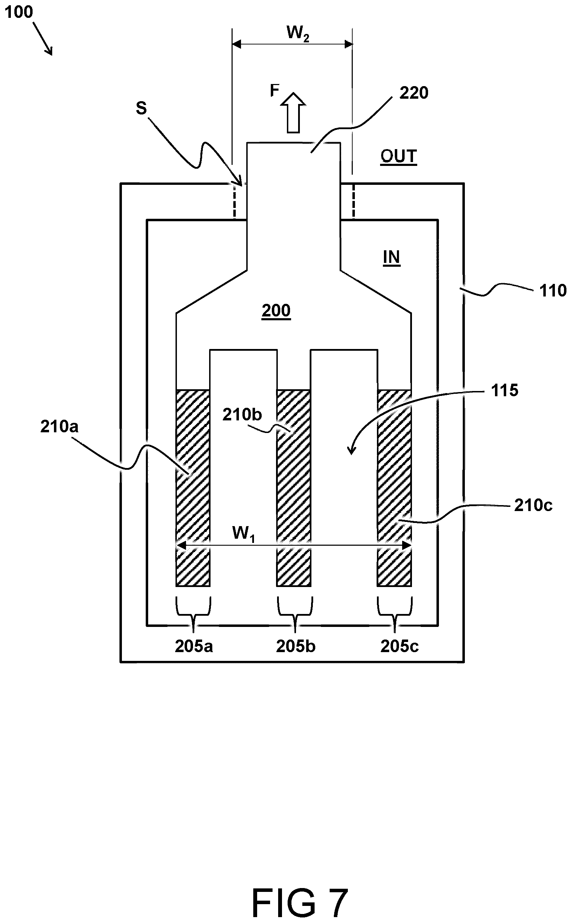

FIG. 7 illustrates provides a top view of an embodiment of the electronic device 100, in which the flexible substrate 200 has multiple branches 205a-c. The branches 205a-c are interconnected at the pull tab 220. Each branch 205a-c comprises an attachment area 210a, 210b, 210c that is attached to a respective mounting plane 115 on the inside of the compartment. By applying a mechanical pull force F on the pull tab 220, each of the branches 205a-c is peeled off the mounting plane 115 in due to an induced local stress concentration in the bond between the respective attachment area 210a-c and the mounting plane 115, as described herein. Thanks to its flexibility, e.g. bendability and foldability, the substrate 200 can be pulled through a slot S that is smaller than the original size and shape of the flexible substrate 200 as laid out inside the compartment 110. For example, as can be seen in FIG. 7, the slot width W2 is smaller than the maximum width W3 of the flexible substrate 200.

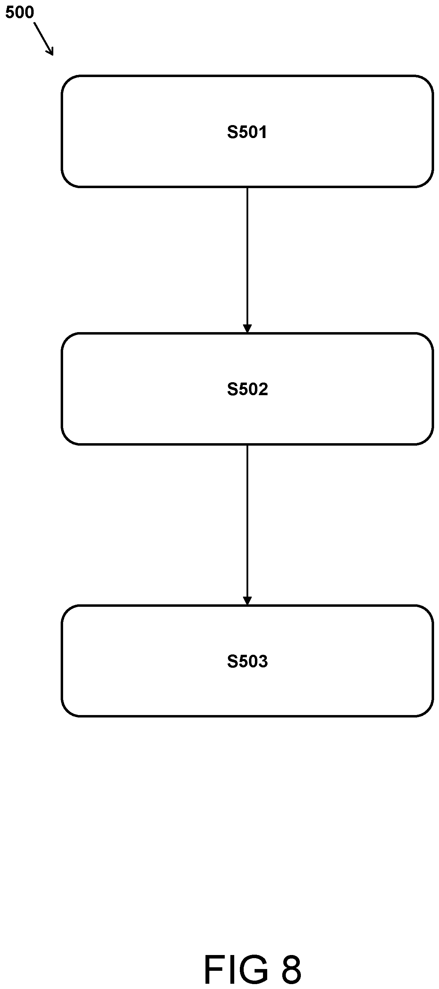

FIG. 8 provides a schematic representation of a method 500 for removing a set of electronics from the electronic device 100 described herein. The method 500 comprises accessing (S501) the pull tab of the flexible substrate from an outside of the casing, applying (S502) a mechanical pull force on the tab, and removing (S503) the flexible substrate in its entirety from the compartment by continuing the mechanical pull force to pull the flexible substrate through the slot.

It will be clear to the skilled person that the invention is not limited to any specific embodiment herein described and that combinations or modifications are possible, in as far as these can be considered within the scope of the appended claims. Also kinematic inversions are considered inherent to the invention disclosed herein. In the claims, any reference signs shall not be construed as limiting the claim.

The terms 'comprising' and 'including' when used in this description or the appended claims should not be construed in an exclusive or exhaustive sense but rather in an inclusive sense. Thus expression as 'including' or 'comprising' as used herein does not exclude the presence of other elements, additional structure or additional acts or steps in addition to those listed. Furthermore, the words 'a' and 'an' shall not be construed as limited to 'only one', but instead are used to mean `at least one', and do not exclude a plurality. Features that are not specifically or explicitly described or claimed may additionally be included in the structure of the invention without departing from its scope.

Expressions such as: "means for ..." should be read as: "component configured for ..." or "member constructed to ..." and should be construed to include equivalents for the structures disclosed. The use of expressions like: "critical", "preferred", "especially preferred" etc. is not intended to limit the invention. To the extent that structure, material, or acts are considered to be essential they are inexpressively indicated as such. Additions, deletions, and modifications within the purview of the skilled person may generally be made without departing from the scope of the invention, as determined by the claims.

## Claims

1. An electronic device, comprising a casing with a compartment that encloses an electronic circuit with one or more circuit parts provided on a flexible substrate, wherein an attachment area of the flexible substrate is attached to a mounting plane inside the compartment, wherein a wall of the compartment comprises a slot that provides a passage between an inside and outside of the compartment, and wherein the flexible substrate comprises a pull tab that extends from the attachment area and passes through the slot such that the pull tab is engageable from the outside of the compartment, wherein a position of the slot with respect to the mounting plane is arranged for causing a local bending and/or stretching of the attachment area in response to a mechanical pull force on the pull tab, for thereby creating a local stress concentration in the attachment area that propagates and detaches the flexible substrate from the mounting plane, and wherein the slot is dimensioned to allow removal of the detached flexible substrate from the compartment through the slot.

2. The electronic device according to claim 1, wherein the slot has a slot height that is between 1 and 3 times a maximum thickness of the flexible substrate including the circuit parts.

3. The electronic device according to any preceding claim, wherein the attachment area is bendable in an out-of-plane direction of the flexible substrate, and wherein the slot is located and/or tilted at an out-of-plane distance and/or orientation relative to the mounting plane that provides a non-zero peel angle of the tab with respect to the mounting plane, such that the attachment area is peeled from the mounting plane in response to a mechanical pull force on the pull tab.

4. The electronic device according to claim 3, wherein the peel angle initially is at least 45 degrees, preferably 90-180 degrees.

5. The electronic device according to any of the preceding claims, wherein the attachment area of the flexible substrate comprises a stretchable section that is stretchable in an in-plane direction, and wherein the stretchable section is stretched in response to a mechanical pull force on the pull tab.

6. The electronic device according to claim 5, wherein the stretchable section has an elongation at break, defined by dividing a length at break of the stretchable section by an original length of the stretchable section, of at least a factor 2.

7. The electronic device according to any of the preceding claims, wherein the attachment area is attached to the mounting plane by an adhesive, wherein the adhesive has a peel strength that is weaker than a tensile strength of the flexible substrate.

8. The electronic device according to any of the preceding claims, wherein the attachment area is connected to the mounting plane by a patterned layer of first adhesive areas and/or second adhesive areas, and/or non-adhesive areas.

9. The electronic device according to any preceding claim, wherein the flexible substrate includes one or more rigid circuit parts.

10. The electronic device according to any preceding claim, wherein the flexible substrate comprises one or more printed circuit parts.

11. The electronic device according to any of the preceding claims, wherein the pull tab is connected to a battery unit of the electronic device.

12. The electronic device according to any of the preceding claims, wherein the casing comprises a removable cover that covers the slot.

13. The electronic device according to claim 12, wherein the removable cover is attached to the pull tab.

14. The electronic device according to any of the preceding claims, wherein the flexible substrate comprises a plurality of branches that are interconnected at the pull tab, wherein each branch comprises an attachment area that is attached to a respective mounting plane on the inside of the casing.

15. A method for removing the set of electronics from the electronic device according to any of the preceding claims, the method comprising accessing the pull tab of the flexible substrate from an exterior of the casing and applying a mechanical pull force on the pull tab.
